(19) Europäisches Patentamt / European Patent Office / Office européen des brevets

(11) **EP 3 363 117 B1**

(12) **EUROPEAN PATENT SPECIFICATION**

(45) Date of publication and mention
of the grant of the patent:
**30.10.2019 Bulletin 2019/44**

(51) Int Cl.:
***H03F 3/189*** *(2006.01)*   ***H03F 3/217*** *(2006.01)*

(21) Application number: **15794527.0**

(22) Date of filing: **10.11.2015**

(86) International application number:
**PCT/EP2015/076150**

(87) International publication number:
**WO 2017/080584 (18.05.2017 Gazette 2017/20)**

(54) **QUADRATURE DIGITAL POWER AMPLIFIER**

LEISTUNGSVERSTÄRKER MIT DIGITALER QUADRATUR

AMPLIFICATEUR DE PUISSANCE NUMÉRIQUE EN QUADRATURE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**22.08.2018 Bulletin 2018/34**

(73) Proprietor: **Huawei Technologies Co., Ltd.
Longgang District
Shenzhen, Guangdong 518129 (CN)**

(72) Inventors:
• **LEHTINEN, Teijo
S-16440 Kista (SE)**
• **WONG, James
80992 Munich (DE)**
• **MACPHAIL, Philip
80992 Munich (DE)**

(74) Representative: **Pfenning, Meinig & Partner mbB
Patent- und Rechtsanwälte
Joachimsthaler Straße 10-12
10719 Berlin (DE)**

(56) References cited:
**US-A1- 2009 311 980    US-A1- 2014 118 063
US-A1- 2014 211 870    US-B1- 6 311 046**

• **"Digital transmitter design for mobile devices",
IEEE COMMUNICATIONS MAGAZINE, IEEE
SERVICE CENTER, PISCATAWAY, US, vol. 51,
no. 10, 1 October 2013 (2013-10-01), pages
114-123, XP011528700, ISSN: 0163-6804, DOI:
10.1109/MCOM.2013.6619574 [retrieved on
2013-10-03]**

## Description

TECHNICAL FIELD

The present invention relates to a quadrature digital power amplifier for converting an IQ data signal to an RF signal. Furthermore, the present invention also relates to a transmitter comprising such a quadrature digital power amplifier. The present invention also relates to a method for converting an IQ data signal to an RF signal.

BACKGROUND

Embodiments of the present invention are related to quadrature digital power amplifiers, which convert digital I/Q signals directly to I/Q modulated analog RF signals. Such devices have various names and abbreviations in literature, such as all-digital quadrature transmitter, Direct Digital to RF Modulator DDRM, Digital to RF Converter DRFC, Digital to RF Amplitude Converter DRAC. However, in this document the device will be called a quadrature Digital Power Amplifier, Q-DPA.

A conventional quadrature Digital Power Amplifiers (Q-DPA) may comprise a unary power cell array in combination with a binary power cell array. If the whole power cell array was unary-coded (thermo-coded), 12 bit (plus sign bit) Q-DPA would require two arrays of 2^12=4096 individually controlled power cells. Routing LO and controls would be challenging and would introduce large amount of parasitic and varying delays to the control, which degrades the Q-DPA performance. In the other extreme if all units were binary coded, only 12 baseband control signals would be needed to control the 12 bit power cell array, but that would mean intolerable glitches and nonlinearity in the middle code region when a large number of separate power cells, corresponding to least significant bits, are turned off and the separate power cells corresponding to the next higher bit is turned on. Furthermore, due to manufacturing tolerances different power cells in the Q-DPA are not identical. This is one reason for the glitches. A power cell may be implemented in various ways. In the example on conventional technology, the power cell is a switch. Another well-known Q-DPA topology is based on switched-capacitors power cells.

A typical solution, as described above, is to have the least significant bit (LSB) units binary-coded and most significant bit (MSB) units unary coded (thermo-coded) but that still requires a large number of unary coded control signals to avoid binary glitches. The physical layout for a Q-DPA with large number of power units and mixed binary and unary coding is very challenging.

US 2014/0118063 A1 describes an RF amplifier architecture with a controller receiving I and Q data and generating first and second further I and Q data for two digital to RF modulators.

SUMMARY

An objective of the present invention is to provide a solution which mitigates or solves the drawbacks and problems of conventional solutions.

Another objective of the present invention is to provide a quadrature digital power amplifier system for converting an IQ data signal to an RF signal and a transmitter device comprising such a system, wherein the quadrature digital power amplifier system is an alternative to conventional quadrature digital power amplifier systems.

Another objective of the present invention is to provide a quadrature digital power amplifier system for converting an IQ data signal to an RF signal and a transmitter device comprising such a system, wherein the quadrature digital power amplifier system enables a simplified layout of the digital-to-RF converter devices in the quadrature digital power amplifier system compared to conventional solutions.

An "or" in this description and the corresponding claims is to be understood as a mathematical OR which covers "and" and "or", and is not to be understood as an XOR (exclusive OR).

The above objectives are fulfilled by the subject matter of the independent claims. Further advantageous implementation forms of the present invention can be found in the dependent claims.

In the following, an IQ data signal is to be understood as a data signal comprising an in-phase data signal or an I data signal and a quadrature data signal or a Q signal.

According to a first aspect of the present invention, a quadrature digital power amplifier system is provided. The quadrature digital power amplifier system comprises a decomposition circuit comprising an input configured to receive an IQ data signal comprising an I data signal and a Q data signal, and a first suboutput and a second suboutput. The decomposition circuit is configured to decompose the IQ data signal into at least a first IQ data subsignal and a second IQ data subsignal, and to output the first IQ data subsignal on the first suboutput and the second IQ data subsignal on the second suboutput. The quadrature digital power amplifier system also comprises a first digital-to-RF converter device comprising a first converter input connected to the first suboutput of the decomposition circuit, a first digital power amplifier connected to the first converter input, and a first output. The first digital-to-RF converter device is configured to convert the first IQ data subsignal to a first RF signal and to output the first RF signal on the first output. The quadrature digital power amplifier system also comprises at least a second digital-to-RF converter device comprising a second converter input connected to the second suboutput of the decomposition circuit, a second digital power amplifier connected to the second converter input, and a second output. The second digital-to-RF converter device is configured to convert the second IQ data subsignal to a second RF signal and to output the second RF signal on the second output. The decomposition circuit is configured to decompose the IQ data signal into at least a first IQ data subsignal not comprising signal components above a first threshold level in the IQ data signal and a second IQ data subsignal comprising said signal components if the signal level of the IQ data signal in a given sample is above the first threshold level.

In this application, radio frequency may mean the frequency range from 1 MHz to 300 GHz.

With a quadrature digital power amplifier system according to the first aspect of the present invention the layout of the first and second digital-to-RF converter devices may be tremendously simplified compared to conventional solutions. Furthermore the binary-coding-glitches may be made significantly smaller since each segment (e.g. each digital-to-RF converter device) can have its own binary coded units instead of reusing the same binary units over the whole array. Also the subarray (e.g. the second digital-to-RF converter device) that is used only for the signal peaks can have a lower resolution and lower efficiency than the subarray(s) (e.g. the first digital-to-RF converter device) used for the main part of the signal, because the peaks are rare and thus do not affect the average efficiency or the spectral content as much as the rest of the signal.

In a first possible implementation form of a quadrature digital power amplifier system according to the first aspect, the first output and the second output are connected to each other.

In order to provide an RF signal corresponding to the IQ data signal, the first RF signal and the second RF signal are combined.

In a second possible implementation form of a quadrature digital power amplifier system according to the first implementation form of the first aspect or to the quadrature digital power amplifier system as such, the IQ data signal is decomposed so that the sum of the first IQ data subsignal and the second IQ data subsignal in the given sample is equal to the IQ data signal in the given sample.

In a third possible implementation form of a quadrature digital power amplifier system according to any of the preceding implementation forms of the first aspect or to the quadrature digital power amplifier system as such, the signal level of the IQ data signal is defined as $I^2+Q^2$, $\sqrt{I^2+Q^2}$, or abs(I) +abs(Q), wherein I is the value of the I data signal and Q is the value of the Q data signal. In principle this corresponds to the amplitude of the signal. This is a favourable definition of the signal level.

In a fourth possible implementation form of a quadrature digital power amplifier system according to any of the preceding implementation forms of the first aspect or to the quadrature digital power amplifier system as such, the decomposition circuit is configured to decompose the I data signal into at least a first I data subsignal and a second I data subsignal, if the signal level of the I data signal in a given sample is above a second threshold level for the I data signal, and decompose the Q data signal into at least a first Q data subsignal and a second Q data subsignal, if the signal level of the Q data signal in a given sample is above a third threshold level for the Q data signal. The first I data subsignal and the first Q data subsignal constitute the first IQ data subsignal, wherein the second I data subsignal and the second Q data subsignal constitute the second IQ data subsignal, and wherein the signal level for the I data signal is defined as abs(I) and the signal level for the Q data signal is defined as abs(Q). Such a decomposition of the IQ data signal may be more easily implemented in some cases.

In a fifth possible implementation form of a quadrature digital power amplifier system according to the fourth possible implementation form of the first aspect the IQ data signal is decomposed so that the sum of the first I data subsignal and the second I data subsignal in the given sample is equal to I data signal in the given sample, and so that the sum of the first Q data subsignal and the second Q data subsignal in a given sample is equal to the Q data signal in the given sample. Similarly to the second possible implementation form it is possible to decompose the I data signal and the Q data signal in other ways. It is for example possible to have some scale factor between the I/Q data signal and the sum of the first I/Q data subsignal and the second I/Q data subsignal as long as the resulting RF signal fulfils the specific system requirements.

Such a decomposition of the IQ data signal may be relatively easily implemented in some cases.

In a sixth possible implementation form of a quadrature digital power amplifier system according to any of the preceding implementation forms of the first aspect or to the quadrature digital power amplifier system as such, at least one of the first and second digital-to-RF converter devices comprises a corresponding decoder connected between the converter input and the digital power amplifier. By having a decoder between the converter input and the digital power amplifier the layout of the digital power amplifier may be simplified. Possibly, also the overall layout of the digital-to-RF converters may be simplified.

In a seventh possible implementation form of a quadrature digital power amplifier system according to the sixth possible implementation form of the first aspect, at least a part of one of the digital power amplifiers is unary coded and the corresponding decoder is configured to provide a unary coded signal to said at least a part of one of the digital power amplifiers. By using unary coding binary glitches are avoided. Due to the simplified layout of each digital power amplifier, which is due to the use of at least two digital power amplifier, the digital power amplifiers are as a whole still less complicated in their layout in comparison with conventional digital power amplifiers.

In an eighth possible implementation form of a quadrature digital power amplifier system according to the sixth or seventh possible implementation form of the first aspect at least a part of one of the first digital power amplifier and the second digital power amplifier is binary coded, wherein the corresponding decoder is configured to provide a binary coded signal to said at least part of one of the first digital power amplifier and the second digital power amplifier. Binary coding simplifies the layout of the digital power amplifier even further. The glitches due to the binary coding are still smaller in the eighth possible implementation form compared to the binary glitches in conventional systems.

A ninth possible implementation form of a quadrature digital power amplifier system according to any of the preceding implementation forms of the first aspect or to the quadrature digital power amplifier system as such, further comprises a first digital quadrature modulator being connected between the first converter input and the first digital power amplifier, and being configured to perform at least one of upconverting and combining the I data subsignal of the first IQ data subsignal and the Q data subsignal of the first IQ data subsignal in the digital domain , and a second digital quadrature modulator being connected between the second converter input and the second digital power amplifier, and being configured to perform at least one of upconverting and combining the I data subsignal of the first IQ data subsignal and the Q data subsignal of the first IQ data subsignal in the digital domain. Combining the I data subsignals and Q data subsignals in the digital domain, instead of the analog domain in the digital power amplifier output, may have advantage in some implementations. For instance, IQ power combination in the analog domain may result in power loss due to quadrature signal cancellation.

A tenth possible implementation form of a quadrature digital power amplifier system according to any of the preceding implementation forms of the first aspect or to the quadrature digital power amplifier system as such, further comprises up-sampling blocks, wherein one up-sampling block is arranged between each one of the suboutputs and the corresponding converter inputs, wherein each up-sampling block is configured to up-sample and filter each IQ data subsignal. The up-sampling blocks contribute to providing a more accurate digital signal. This improves the output RF signals from the outputs.

In an eleventh possible implementation form of a quadrature digital power amplifier system according to any of the preceding implementation forms of the first aspect or to the quadrature digital power amplifier system as such, the decomposition circuit is configured to decompose the IQ data signal into the first IQ data subsignal and the second IQ data subsignal such that signal components (e.g. signal peaks) above the first threshold level in the IQ data signal are comprised in the second IQ data subsignal and are not comprised in the first IQ data subsignal. By such a decomposition it can be achieved that the digital-to-RF converter devices can be efficiently chosen to with regards to needed performance verses implementation cost.

In a twelfth possible implementation form of a quadrature digital power amplifier system according to any of the preceding implementation forms of the first aspect or to the quadrature digital power amplifier system as such, the second digital-to-RF converter device has any of a lower resolution and a lower efficiency than the first digital-to-RF converter device. As the second digital-to-RF converter device is configured to support only the rare signal envelope peaks and due to the rare occurrence of the signal envelope peaks, the output RF signal may still resemble the correct RF signal within the specification limits even with a reduced resolution and/or efficiency. A digital-to-RF converter device with lower resolution and/or lower efficiency can be realized with transistors and/or topologies that support higher voltages, such as thick-oxide transistors and cascade switch topologies.

According to a second aspect of the present invention a method for converting an IQ data signal to an RF signal is provided. The method comprises the steps of receiving an IQ data signal comprising an I data signal and a Q data signal, decomposing the IQ data signal into at least a first IQ data subsignal not comprising signal components above a first threshold level in the IQ data signal and a second IQ data subsignal comprising said signal components if the signal level of the IQ data signal if the signal level of the IQ data signal in a given sample is above a first threshold level, converting the first IQ data subsignal to a first RF signal, and converting the second IQ data subsignal to a second RF signal.

With a method according to the second aspect of the present invention the implementation of the conversion is simplified in comparison with conventional methods. Furthermore the binary-coding-glitches may be made significantly smaller since each segment can be implemented with its own binary coded units instead of reusing the same binary units over the whole array.

In a first possible implementation form of a method according to the second aspect the IQ data signal is decomposed so that the sum of the first IQ data subsignal and the second IQ data subsignal in the given sample is equal to the IQ data signal in the given sample. Such a decomposition of the IQ data signal may be relatively easily implemented in most cases. It is, however, possible to decompose the IQ data signal in other ways so that the sum of the first IQ data subsignal and the second IQ data subsignal in the given sample is not equal to the IQ data signal in the given sample. It is for example possible to have some scale factor between the IQ data signal and the sum of the first IQ data subsignal and the second IQ data subsignal as long as the resulting RF signal resembles the ideal RF signal.

In a second possible implementation form of a method according to the first possible implementation form of the second aspect or to the method for converting an IQ data signal to an RF signal as such, the signal level of the IQ data signal is defined as $I^2+Q^2$, $\sqrt{I^2+Q^2}$, or abs(I) +abs(Q). This corresponds in principal to the amplitude of the IQ data signal.

In a third possible implementation form of a method according to any of the preceding implementation forms of the second aspect or to the method for converting an IQ data signal to an RF signal as such, the step of decomposing comprises the step of decomposing the I data signal into at least a first I data subsignal and a second I data subsignal, if the signal level of the I data signal in a given sample is above a second threshold level for the I data signal, and decomposing the Q data signal into at least a first Q data subsignal and a second Q data subsignal, if the signal level of the Q data signal in a given sample is above a third threshold level for the Q data signal, wherein the first I data subsignal and the first Q data subsignal constitutes the first IQ data subsignal IQ1, wherein the second I data subsignal and the second Q data subsignal constitutes the second IQ data subsignal, and wherein the signal level for the I data signal is defined as abs(I) and the signal level for the Q data signal is defined as abs(Q). Such a decomposition of the IQ data signal may be more easily implemented in some cases.

In a fourth possible implementation form of a method according to any of the preceding implementation forms of the second aspect or to the method for converting an IQ data signal to an RF signal as such, the IQ data signal is decomposed so that the sum of the first I data subsignal and the second I data subsignal in the given sample is equal to I data signal in the given sample, and so that the sum of the first Q data subsignal and the second Q data subsignal in a given sample is equal to the Q data signal in the given sample. Such a decomposition of the IQ data signal may be relatively easily implemented in some cases. Similarly to the first possible implementation form it is possible to decompose the I data signal and the Q data signal in other ways. It is for example possible to have some scale factor between the I/Q data signal and the sum of the first I/Q data subsignal and the second I/Q data subsignal as long as the resulting RF signal resembles the ideal RF signal.

In a fifth possible implementation form of a method according to the fourth possible implementation form of the second aspect, the method comprises the step of unary coding at least a part of one of the first IQ data subsignal and the second IQ data subsignal before the conversion step. This step reduces the binary coding glitches. A part of the first IQ data subsignal and the second IQ data subsignal may be kept binary coded to reduce the amount of control signals.

In a sixth possible implementation form of a method according to any of the preceding implementation forms of the second aspect or to the method for converting an IQ data signal to an RF signal as such, the method comprises the steps of upconverting and combining the I data subsignal of the first IQ data subsignal and the Q data subsignal of the first IQ data subsignal in the digital domain, and upconverting and combining the I data subsignal of the first IQ data subsignal and the Q data subsignal of the first IQ data subsignal in the digital domain. Combining the the I data signals and Q data signals in the digital domain, instead of the analog domain in the digital power amplifier output, may be advantageous in some implementations. For instance, IQ power combination in the analog domain may result in power loss due to quadrature signal cancellation.

In a seventh possible implementation form of a method according to any of the preceding implementation forms of the second aspect or to the method for converting an IQ data signal to an RF signal as such, the method comprises the steps up-sampling and filtering each IQ data subsignal. The up-sampling blocks contribute to providing a more accurate digital signal and thus better resulting RF signals.

In an eighth possible implementation form of a method according to any of the preceding implementation forms of the second aspect or to the method for converting an IQ data signal to an RF signal as such, the IQ data signal is decomposed into the first IQ data subsignal and the second IQ data subsignal such that signal components (e.g. signal peaks) above the first threshold level in the IQ data signal are comprised in the second IQ data subsignal and are not comprised in the first IQ data subsignal.

According to a third aspect of the present invention a transmitter device for a wireless communication system is provided which comprises a quadrature digital power amplifier system according to the first aspect of the present invention. The third aspect provides similar advantages as was described for the first aspect.

According to a fourth aspect of the present invention a computer program is provided which computer program comprises a program code for performing a method according to the second aspect of the invention, when the computer program runs on a computer. The third aspect provides similar advantages as was described for the first aspect.

SHORT DESCRIPTION OF THE DRAWINGS

Fig. 1 shows schematically a quadrature digital power amplifier system according to a first embodiment of the present invention, which quadrature digital power amplifier system comprises digital-to-RF converter devices.

Fig 2 shows a digital-to-RF converter device according to an embodiment of the present invention.

Fig 3 shows a digital-to-RF converter device according to another embodiment of the present invention.

Fig 4 shows a digital-to-RF converter device according to a further embodiment of the present invention.

Fig. 5 shows schematically a quadrature digital power amplifier system according to a second embodiment of the present invention.

Fig. 6 shows schematically a quadrature digital power amplifier system according to a third embodiment of the present invention.

Fig. 7 is a flow diagram over a method according to an embodiment of the present invention.

Fig. 8 shows schematically a transmitter device for a wireless communication system comprising a quadrature digital power amplifier system according to any one of the embodiments described above.

DETAILED DESCRIPTION OF THE EMBODIMENTS

In the following detailed description of the embodiments of the invention, the same reference numeral will be used for the corresponding feature in the different drawings.

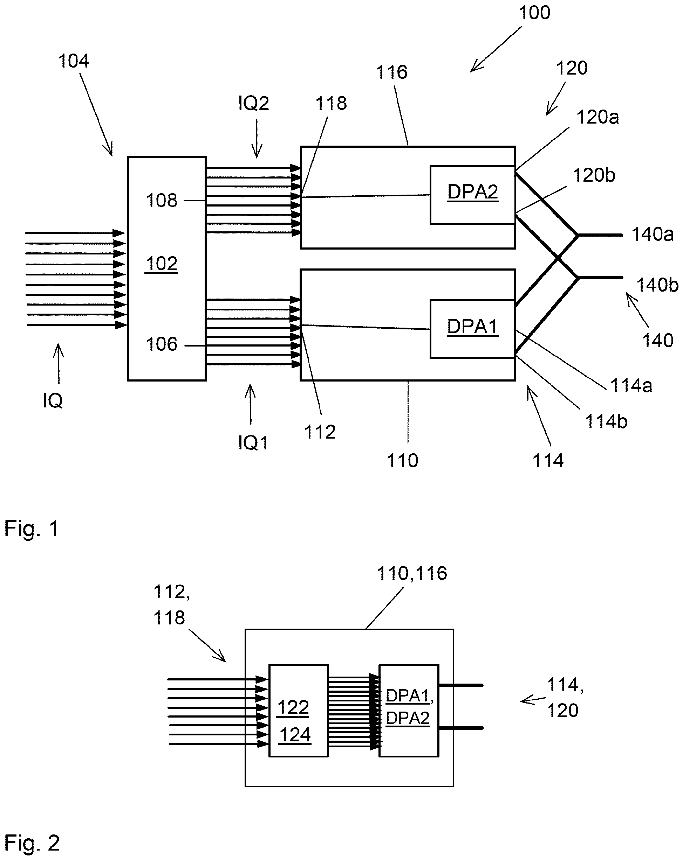

Fig. 1 shows schematically a quadrature digital power amplifier system 100 according to an embodiment of the present invention. The quadrature digital power amplifier system 100 comprises a decomposition circuit 102 as shown in Fig. 1. The decomposition circuit 102 comprises an input 104 configured to receive an IQ data signal IQ comprising an I data signal and a Q data signal, and a first suboutput 106 and a second suboutput 108. The IQ data signal is in Fig. 1 shown as a number of arrows, the arrows representing the different bits of the digital signal. The decomposition circuit 102 receives the IQ data signal and is configured to decompose the IQ data signal IQ into at least a first IQ data subsignal IQ1 and a second IQ data subsignal IQ2 if the signal level of the IQ data signal IQ in a given sample is above a first threshold level. The decomposition circuit 102 is further configured to output the first IQ data subsignal IQ1 on the first suboutput 106 and the second IQ data subsignal IQ2 on the second suboutput 108. The subsignals IQ1 and IQ2 are also shown with as a number of arrows, the arrows representing the different bits of the digital signal.

As an example the decomposition of the IQ data signal into the two IQ data subsignals IQ1 and IQ2 can be performed such that all signal components of the IQ data signal IQ above the first threshold level are comprised in the second IQ data subsignal IQ2 but not in the first IQ data subsignal IQ1 and all signal components of the IQ data signal IQ below or equal to the first threshold level are comprised in the first IQ data subsignal IQ1 but not in the second IQ data subsignal IQ2.

The signal level of the IQ data signal IQ is according to an embodiment defined as $I^2 + Q^2$,

$$\sqrt{I^2 + Q^2},$$ or abs(I) +abs(Q).

I is the value of the I data signal and Q is the value of the Q data signal.

The quadrature digital power amplifier system 100 also comprises a first digital-to-RF converter device 110 comprising a first converter input 112 connected to the first suboutput 106 of the decomposition circuit 102, a first digital power amplifier DPA1 connected to the first converter input 112, and a first output 114. The first digital-to-RF converter device 110 is configured to convert the first IQ data subsignal IQ1 to a first RF signal and to output the first RF signal on the first output 114. Said conversion to a first RF signal is performed by the first digital power amplifier DPA1 in the embodiment shown in Fig. 1. The quadrature digital power amplifier system 100 also comprises at least a second digital-to-RF converter device 116 comprising a second converter input 118 connected to the second suboutput 108 of the decomposition circuit 102, a second digital power amplifier DPA2 connected to the second converter input 118, and a second output 120. The second digital-to-RF converter device 116 is configured to convert the second IQ data subsignal IQ2 to a second RF signal and to output the second RF signal on the second output 120. Said conversion to a second RF signal is performed by the second digital power amplifier DPA2 in the embodiment shown in Fig. 1. The first output 114 comprises a first positive output 114a and a first negative output 114b while the second output 120 comprises a second positive output 120a and a second negative output 120b. As can be seen in the embodiment shown in Fig 1 the first output 114 and the second output 120 are connected to each other. The common output 140 comprises a common positive output 140a which is connected to the first positive output 114a and the second positive output 120a. The common output 140 also comprises a common negative output 140b which is connected to the first negative output 114b and the second negative output 120b. The RF signal is output on the common output 140. The common output may be connected to, e.g., at least one of an impedance matching network, power combiner, filter, switch, and an antenna on a transmitter. Although the outputs shown in Figure 1 and the following figures are differential outputs according to further embodiments, the outputs can be single ended outputs.

Fig. 2 shows a digital-to-RF converter device 110, 116, according to an embodiment of the present invention. The digital-to-RF converter device 110, 116, in Fig. 2 comprises a corresponding decoder 122, 124, connected between the converter input 112, 118, and the digital power amplifier DPA1, DPA2. The decoder 122, 124, is separate from the digital power amplifier DPA1, DPA2, and decodes part of the IQ data subsignal IQ1, IQ2 from binary coded digital signals into a combination of unary coded and binary coded signals which are transmitted to the digital power amplifier DPA1, DPA2. Unary coding increases the complexity but reduces the amount of glitches caused by binary coding. The increased complexity is represented by an increased number of arrows from the decoder 122, 124, in comparison with the number of arrows on the input of the decoder 122, 124.

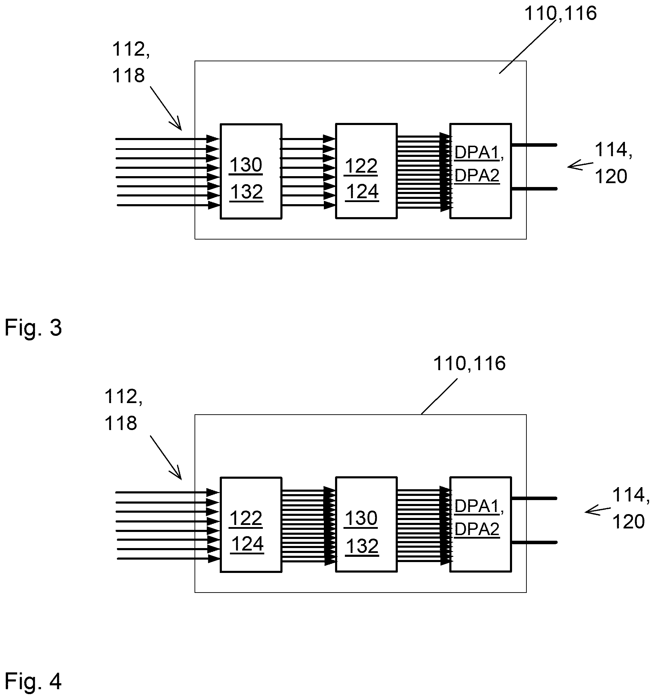

Figs. 3 and 4 show a digital-to-RF converter device 110, 116, according to further embodiments of the present invention. The digital-to-RF converter device 110, 116, of Fig. 3 and Fig. 4 additionally comprises a digital quadrature modulator 130, 132, being connected between the first converter input 112, 118 and the digital power amplifier DPA1, and being configured to upconvert the IQ data subsignal IQ1, IQ2, to an RF signal in the digital domain.

In the embodiment shown in Fig 3, the digital quadrature modulator 130, 132, is connected between the converter input 112, 118, and the decoder 122, 124. In Fig. 4 the digital quadrature modulator 130, 132, is arranged between the decoder 122, 124 and the digital power amplifier DPA1, DPA2. The choice between the embodiment in Fig. 3 and Fig. 4 depends among other things on how the decoder 122, 124, is arranged. In case the decoder is configured to decode the IQ data subsignal IQ1, IQ2, into unary coded signals the decoder 122, 124, has to output a large number of control signals. In this case it might be favourable to have the decoder arranged after the digital quadrature modulator 130, 132, as shown in the embodiment in Fig. 3.

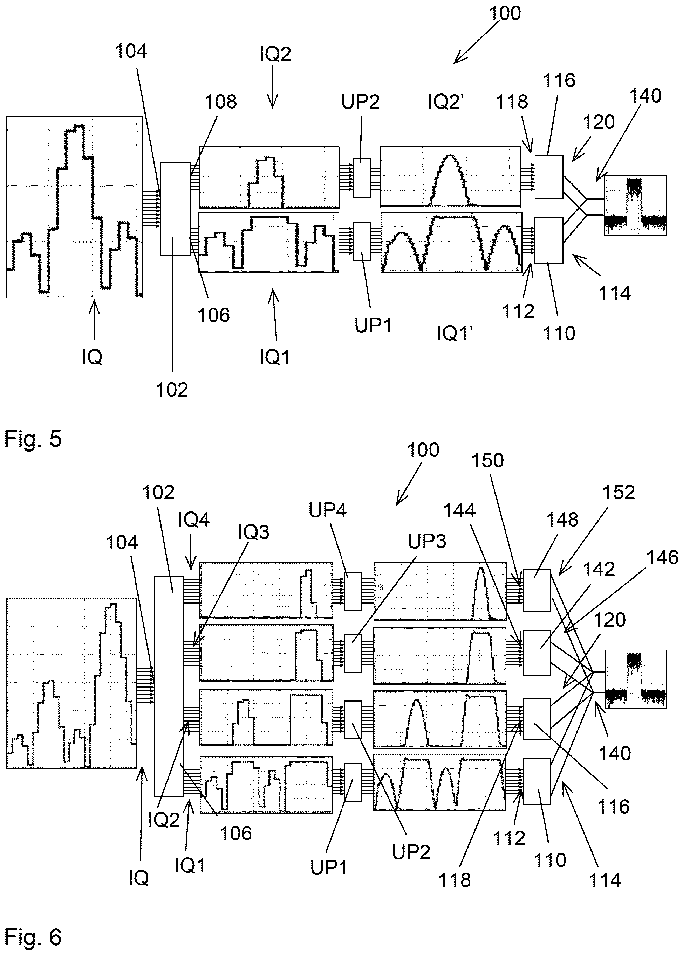

Fig. 5 shows schematically a quadrature digital power amplifier system 100 according to a further embodiment of the present invention. In Fig. 5 the shape with respect to time of the IQ data signal and the IQ data subsignals IQ1, IQ2, are shown schematically. The difference between the embodiment shown in Fig. 1 and the embodiment shown in Fig. 5 is that the quadrature digital power amplifier system 100 shown in Fig. 5 comprises up-sampling blocks UP1, UP2, wherein one up-sampling block UP1, UP2, is arranged between each one of the suboutputs 106, 108, and the corresponding converter inputs 112, 118, wherein each up-sampling block UP1, UP2, is configured to up-sample and filter each IQ data subsignal.

As is shown in Fig. 5, the IQ data signal is decomposed by the decomposition circuit 102 into a first IQ data subsignal IQ1 and a second IQ data subsignal IQ2. The up-sampling blocks UP1, UP2, then up-samples the first IQ data subsignal IQ1 and the second IQ data subsignal IQ2 into a first up-sampled IQ data subsignal IQ1' and a second up-sampled IQ data subsignal IQ2'. The first up-sampled IQ data subsignal IQ1' and a second up-sampled IQ data subsignal IQ2' are then converted by the first digital-to-RF converter device 110 and the second digital-to-RF converter device 116 to a first RF signal and a second RF signal which are output on the first output 114 and the second output 120, respectively.

Fig. 6 shows schematically a quadrature digital power amplifier system 100 according to a third embodiment of the present invention. The quadrature digital power amplifier system 100 in Fig. 6 comprises a decomposition circuit 102 which is configured to decompose the IQ data signal IQ into four IQ data subsignals IQ1, IQ2, IQ3, IQ4. The quadrature digital power amplifier system 100 in Fig. 6 comprises four up-sampling blocks UP1, UP2, UP3, UP4, which are configured to up-sample and filter each IQ data subsignal IQ1, IQ2, IQ3, IQ4. The quadrature digital power amplifier system 100 also comprises a first digital-to-RF converter device 110 comprising a first converter input 112 and a first output 114, a second digital-to-RF converter device 116 comprising a second converter input 118 and a second output 120, a third digital-to-RF converter device 142 comprising a third converter input 144 and a third output 146, and a fourth digital-to-RF converter device 148 comprising a fourth converter input 150 and a fourth output 152. The first output 114, the second output 120, the third output 144 and the fourth output 148 are connected into a common output 140 on which an RF-signal RF, is output.

Thus, in operation the IQ data signal IQ is decomposed into four IQ data subsignals IQ1, IQ2, IQ3, IQ4. The IQ data subsignals are up-sampled by the up-sampling blocks UP1, UP2, UP3, UP4 and input into the first digital-to-RF converter device 110, the second digital-to-RF converter device 116, the third digital-to-RF converter device 142, and the fourth digital-to-RF converter device 146. By dividing the IQ data signal IQ into four IQ data subsignals IQ1, IQ2, IQ3, IQ4, instead of only two the complexity of the converter devices 110, 116, 142, 146, may be further decreased.

In the embodiment shown in Fig. 5, the decomposition circuit 102 is configured to decompose the IQ data signal IQ into at least a first IQ data subsignal IQ1 and a second IQ data subsignal IQ2 if the signal level of the IQ data signal IQ in a given sample is above a first threshold level, and to output the first IQ data subsignal IQ1 on the first suboutput 106 and the second IQ data subsignal IQ2 on the second suboutput 108. The signal level of the IQ data signal IQ is according to an embodiment defined as $I^2+Q^2$, $\sqrt{I^2+Q^2}$, or abs(I) +abs(Q).

In the embodiment shown in Fig. 6, three different threshold levels are used, wherein the IQ data signal is decomposed into a first IQ data subsignal IQ1, a second IQ data subsignal IQ2, a third IQ data subsignal IQ3, and a fourth IQ data subsignal IQ4. As an example the decomposition of the IQ data signal into the four IQ data subsignals IQ1, IQ2, IQ3 and IQ4, can be performed in the following way. All signal components of the IQ data signal IQ below or equal to the first threshold level are comprised in the first IQ data subsignal IQ1 but not in the second IQ data subsignal IQ2, the third IQ data subsignal IQ3, or the fourth IQ data subsignal IQ4. All signal components of the IQ data signal IQ above the first threshold level and below or equal to the second threshold level are comprised in the second IQ data subsignal IQ2, but not in the first IQ data subsignal IQ1, the third IQ data subsignal IQ3, or the fourth IQ data subsignal IQ4. All signal components of the IQ data signal IQ above the second threshold level and below or equal to the third threshold level are comprised in the third IQ data subsignal IQ3, but not in the first IQ data subsignal IQ1, the second IQ data subsignal IQ2, or the fourth IQ data subsignal IQ4. Finally, all signal components of the IQ data signal IQ above the third threshold level are comprised in the fourth IQ data subsignal IQ4, but not in the first IQ data subsignal IQ1, the second IQ data subsignal IQ2, or the third IQ data subsignal IQ3. The IQ data subsignals IQ1, IQ2, IQ3, IQ4, are shown both before and after the up-sampling blocks UP1, UP2, UP3, UP4, in Fig. 6.

The embodiment shown in Fig. 6 may also be used to describe a method in which the I data signal is decomposed into at least a first I data subsignal and a second I data subsignal, if the signal level of the I data signal in a given sample is above a second threshold level for the I data signal, and the Q data signal is decomposed into at least a first Q data subsignal and a second Q data subsignal, if the signal level of the Q data signal in a given sample is above a third threshold level for the Q data signal. The first I data subsignal should then correspond to IQ1 and the first Q data subsignal should correspond to IQ2 and together constitute the first IQ data subsignal. The second I data subsignal should correspond to IQ3 and the second Q data subsignal should correspond to IQ4 and together constitute the second IQ data subsignal. The signal level for the I data signal is defined as abs(I) and the signal level for the Q data signal is defined as abs(Q). According to an embodiment, the sum of the first I data subsignal and the second I data subsignal in the given sample is equal to I data signal in the given sample. According to an embodiment, the sum of the first Q data subsignal and the second Q data subsignal in a given sample is equal to the Q data signal in the given sample.

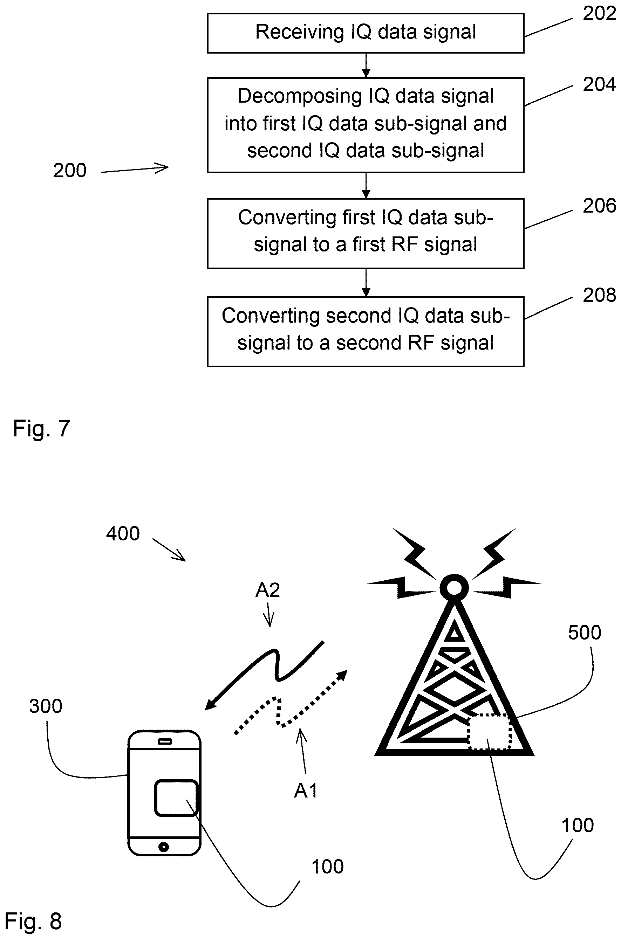

Fig. 7 is a flow diagram over a method according to the present invention. The method 200 for converting an IQ data signal IQ to an RF signal comprises the steps of receiving 202 an IQ data signal IQ comprising an I data signal and a Q data signal, decomposing 204 the IQ data signal IQ into at least a first IQ data subsignal IQ1 and a second IQ data subsignal IQ2 if the signal level of the IQ data signal IQ in a given sample is above a first threshold level, converting 206 the first IQ data subsignal IQ1 to a first RF signal, and converting 208 the second IQ data subsignal IQ2 to a second RF signal.

Fig. 8 shows schematically a transmitter device 300 for a wireless communication system 400 comprising a quadrature digital power amplifier system 100 according to any one of the embodiments described above. The wireless communication system 400 also comprises a base station 500 which may also comprise a quadrature digital power amplifier system 100 according to any one of the embodiments described above. The dotted arrow A1 represents transmissions from the transmitter device 300 to the base station 500. The full arrow A2 represents transmissions from the base station 500 to the transmitter device 300.

The present transmitter device 300 may be any of a User Equipment (UE) in Long Term Evolution (LTE), mobile station (MS), wireless terminal or mobile terminal which is enabled to communicate wirelessly in a wireless communication system, sometimes also referred to as a cellular radio system. The UE may further be referred to as mobile telephones, cellular telephones, computer tablets or laptops with wireless capability. The UEs in the present context may be, for example, portable, pocket-storable, hand-held, computer-comprised, or vehicle-mounted mobile devices, enabled to communicate voice or data, via the radio access network, with another entity, such as another receiver or a server. The UE can be a Station (STA), which is any device that contains an IEEE 802.11-conformant Media Access Control (MAC) and Physical Layer (PHY) interface to the Wireless Medium (WM).

The present base station 500 may be a (radio) network node or an access node or an access point or a base station, e.g., a Radio Base Station (RBS), which in some networks may be referred to as transmitter, "eNB", "eNodeB", "NodeB" or "B node", depending on the technology and terminology used. The radio network nodes may be of different classes such as, e.g., macro eNodeB, home eNodeB or pico base station, based on transmission power and thereby also cell size. The radio network node can be a Station (STA), which is any device that contains an IEEE 802.11-conformant Media Access Control (MAC) and Physical Layer (PHY) interface to the Wireless Medium (WM).

## Claims

1.   A quadrature digital power amplifier system (100) comprising:

   a decomposition circuit (102) comprising:

      an input (104) configured to receive an IQ data signal (IQ) comprising an I data signal and a Q data signal; and
      a first suboutput (106) and a second suboutput (108), wherein the decomposition circuit (102) is configured to decompose the IQ data signal (IQ) into at least a first IQ data subsignal (IQ1) and a second IQ data subsignal (IQ2), and to output the first IQ data subsignal (IQ1) on the first suboutput (106) and the second IQ data subsignal (IQ2) on the second suboutput (108);

      a first digital-to-RF converter device (110) comprising a first converter input (112) connected to the first suboutput (106) of the decomposition circuit (102), a first digital power amplifier (DPA1) connected to the first converter input (112), and a first output (114), wherein the first digital-to-RF converter device (110) is configured to convert the first IQ data subsignal (IQ1) to a first RF signal and to output the first RF signal on the first output (114);

at least a second digital-to-RF converter device (116) comprising a second converter input (118) connected to the second suboutput (108) of the decomposition circuit (102), a second digital power amplifier (DPA2) connected to the second converter input (118), and a second output (120), wherein the second digital-to-RF converter device (116) is configured to convert the second IQ data subsignal (IQ2) to a second RF signal and to output the second RF signal on the second output (120)

**characterized in that**

the decomposition circuit (102) is configured to decompose the IQ data signal (IQ) into at least a first IQ data subsignal (IQ1) not comprising signal components above a first threshold level in the IQ data signal (IQ) and a second IQ data subsignal (IQ2) comprising said signal components if the signal level of the IQ data signal (IQ) in a given sample is above the first threshold level.

2. The quadrature digital power amplifier system (100) according to claim 1, wherein the first output (114) and the second output (120) are connected to each other.

3. The quadrature digital power amplifier system (100) according to claim 1 or 2, wherein the IQ data signal (IQ) is decomposed so that the sum of the first IQ data subsignal (IQ1) and the second IQ data subsignal (IQ2) in the given sample is equal to the IQ data signal (IQ) in the given sample.

4. The quadrature digital power amplifier system (100) according to claim 1, 2 or 3, wherein the signal level of the IQ data signal (IQ) is defined as $I^2+Q^2$, $\sqrt{I^2+Q^2}$, or abs(I) +abs(Q), wherein I is the value of the I data signal and Q is the value of the Q data signal.

5. The quadrature digital power amplifier system (100) according to any one of the preceding claims, wherein the decomposition circuit (102) is configured to:

   decompose the I data signal into at least a first I data subsignal and a second I data subsignal, if the signal level of the I data signal in a given sample is above a second threshold level for the I data signal; and

decompose the Q data signal into at least a first Q data subsignal and a second Q data subsignal, if the signal level of the Q data signal in a given sample is above a third threshold level for the Q data signal,

wherein the first I data subsignal and the first Q data subsignal constitutes the first IQ data subsignal (IQ1), wherein the second I data subsignal and the second Q data subsignal constitutes the second IQ data subsignal, and wherein the signal level for the I data signal is defined as abs(I) and the signal level for the Q data signal is defined as abs(Q).

6. The quadrature digital power amplifier system (100) according to claim 5, wherein the IQ data signal (IQ) is decomposed so that the sum of the first I data subsignal and the second I data subsignal in the given sample is equal to I data signal in the given sample, and so that the sum of the first Q data subsignal and the second Q data subsignal in a given sample is equal to the Q data signal in the given sample.

7. The quadrature digital power amplifier system (100) according to any one of the preceding claims, wherein at least one of the first and second digital-to-RF converter devices (110, 116) comprises a corresponding decoder (122, 124) connected between the converter input (112, 118) and the digital power amplifier (DPA1, DPA2).

8. The quadrature digital power amplifier system (100) according to claim 7, wherein at least a part of one of the digital power amplifiers (DPA1, DPA2) is unary coded and wherein the corresponding decoder (122, 124) is configured to provide a unary coded signal to said at least a part of one of the digital power amplifiers (DPA1, DPA2).

9. The quadrature digital power amplifier system (100) according to claim 7 or 8, wherein at least a part of one of the first digital power amplifier (DPA1) and the second digital power amplifier (DPA2) is binary coded and wherein the corresponding decoder (122, 124) is configured to provide a binary coded signal to said at least part of one of the first digital power amplifier (DPA1) and the second digital power amplifier (DPA2).

10. The quadrature digital power amplifier system (100) according to any of the preceding claims, further comprising:

   a first digital quadrature modulator (130) being connected between the first converter input (112) and the first digital power amplifier (DPA1),

and being configured to perform at least one of upconverting and combining the I data subsignal of the first IQ data subsignal (IQ1) and the Q data subsignal of the first IQ data subsignal (IQ1) in the digital domain;
a second digital quadrature modulator (132) being connected between the second converter input (118) and the second digital power amplifier (DPA2), and being configured to perform at least one of upconverting and combining the I data subsignal of the second IQ data subsignal (IQ2) and the Q data subsignal of the second IQ data subsignal (IQ2) in the digital domain.

11. The quadrature digital power amplifier system (100) according to any one of the preceding claims, further comprising:
up-sampling blocks (UP1, UP2), wherein one up-sampling block is arranged between each one of the suboutputs (106, 108) and the corresponding converter inputs (112, 118), wherein each up-sampling block (UP1, UP2) is configured to up-sample and filter each IQ data subsignal.

12. The quadrature digital power amplifier system (100) according to any one of the preceding claims, , wherein the second digital-to-RF converter device (116) has any of a lower resolution and a lower efficiency than the first digital-to-RF converter device (110).

13. A transmitter device (300) for a wireless communication system (400) comprising a quadrature digital power amplifier system (100) according to any one of the preceding claims.

14. A method (200) for converting an IQ data signal (IQ) to an RF signal comprising the steps of:

receiving (202) an IQ data signal (IQ) comprising an I data signal and a Q data signal;
decomposing (204) the IQ data signal (IQ) into at least a first IQ data subsignal (IQ1) and a second IQ data subsignal (IQ2);
converting (206) the first IQ data subsignal (IQ1) to a first RF signal; and
converting (208) the second IQ data subsignal (IQ2) to a second RF signal
**characterized by**
decomposing the IQ data signal (IQ) into at least a first IQ data subsignal (IQ1) not comprising signal components above a first threshold level in the IQ data signal (IQ) and a second IQ data subsignal (IQ2) comprising said signal components if the signal level of the IQ data signal (IQ) in a given sample is above the first threshold level.

**Patentansprüche**

1. Digitales Quadraturleistungsverstärkersystem (100), aufweisend:

eine Zerlegungsschaltung (102), aufweisend:

einen Eingang (104), der konfiguriert ist, ein IQ-Datensignal (IQ), das ein I-Datensignal und ein Q-Datensignal aufweist, zu empfangen; und
einen ersten Teilausgang (106) und einen zweiten Teilausgang (108), wobei die Zerlegungsschaltung (102) konfiguriert ist, das IQ-Datensignal (IQ) in mindestens ein erstes IQ-Datenteilsignal (IQ1) und ein zweites IQ-Datenteilsignal (IQ2) zu zerlegen und das erste IQ-Datenteilsignal (IQ1) am ersten Teilausgang (106) und das zweite IQ-Datenteilsignal (IQ2) am zweiten Teilausgang (108) auszugeben;

eine erste Digital-zu-HF-Wandlervorrichtung (110), die einen ersten Wandlereingang (112), der mit dem ersten Teilausgang (106) der Zerlegungsschaltung (102) verbunden ist, einen ersten digitalen Leistungsverstärker (DPA1), der mit dem ersten Wandlereingang (112) verbunden ist, und einen ersten Ausgang (114) aufweist, wobei die erste Digital-zu-HF-Wandlervorrichtung (110) konfiguriert ist, das erste IQ-Datenteilsignal (IQ1) in ein erstes HF-Signal umzuwandeln und das erste HF-Signal am ersten Ausgang (114) auszugeben;
mindestens eine zweite Digital-zu-HF-Wandlervorrichtung (116), die einen zweiten Wandlereingang (118), der mit dem zweiten Teilausgang (108) der Zerlegungsschaltung (102) verbunden ist, einen zweiten digitalen Leistungsverstärker (DPA2), der mit dem zweiten Wandlereingang (118) verbunden ist, und einen zweiten Ausgang (120) aufweist, wobei die zweite Digital-zu-HF-Wandlervorrichtung (116) konfiguriert ist, das zweite IQ-Datenteilsignal (IQ2) in ein zweites HF-Signal umzuwandeln und das zweite HF-Signal am zweiten Ausgang (120) auszugeben,
**dadurch gekennzeichnet, dass**
die Zerlegungsschaltung (102) konfiguriert ist, das IQ-Datensignal (IQ) in mindestens ein erstes IQ-Datenteilsignal (IQ1), das keine Signalkomponenten oberhalb eines ersten Schwellenpegels in dem IQ-Datensignal (IQ) aufweist, und ein zweites IQ-Datenteilsignal (IQ2), das die Signalkomponenten aufweist, umzuwandeln, wenn der Signalpegel des IQ-Datensignals (IQ) in einer gegebenen Probe oberhalb des ersten Schwellenpegels liegt.

**2.** Digitales Quadraturleistungsverstärkersystem (100) nach Anspruch 1, wobei der erste Ausgang (114) und der zweite Ausgang (120) miteinander verbunden sind.

**3.** Digitales Quadraturleistungsverstärkersystem (100) nach Anspruch 1 oder 2, wobei das IQ-Datensignal (IQ) derart zerlegt ist, dass die Summe aus dem ersten IQ-Datenteilsignal (IQ1) und dem zweiten IQ-Datenteilsignal (IQ2) in der gegebenen Probe gleich dem IQ-Datensignal (IQ) in der gegebenen Probe ist.

**4.** Digitales Quadraturleistungsverstärkersystem (100) nach Anspruch 1, 2 oder 3, wobei der Signalpegel des IQ-Datensignals (IQ) definiert ist als I2 + Q2, $\sqrt{I^2 + Q^2}$, oder abs(I) + abs(Q), wobei I der Wert des I-Datensignals ist und Q der Wert des Q-Datensignals ist.

**5.** Digitales Quadraturleistungsverstärkersystem (100) nach einem der vorhergehenden Ansprüche, wobei die Zerlegungsschaltung (102) konfiguriert ist:

das I-Datensignal in mindestens ein erstes I-Datenteilsignal und ein zweites I-Datenteilsignal zu zerlegen, wenn der Signalpegel des I-Datensignals in einer gegebenen Probe oberhalb eines zweiten Schwellenpegels für das I-Datensignal liegt; und
das Q-Datensignal in mindestens ein erstes Q-Datenteilsignal und ein zweites Q-Datenteilsignal zu zerlegen, wenn der Signalpegel des Q-Datensignals in einer gegebenen Probe oberhalb eines dritten Schwellenpegels für das Q-Datensignal liegt, wobei das erste I-Datenteilsignal und das erste Q-Datenteilsignal das erste IQ-Datenteilsignal (IQ1) bilden, wobei das zweite I-Datenteilsignal und das zweite Q-Datenteilsignal das zweite IQ-Datenteilsignal bilden, und wobei der Signalpegel für das I-Datensignal definiert ist als abs(I) und der Signalpegel für das Q-Datensignal definiert ist als abs(Q).

**6.** Digitales Quadraturleistungsverstärkersystem (100) nach Anspruch 5, wobei das IQ-Datensignal (IQ) derart zerlegt ist, dass die Summe aus dem ersten I-Datenteilsignal und dem zweiten I-Datenteilsignal in der gegebenen Probe gleich dem I-Datensignal in der gegebenen Probe ist, und derart, dass die Summe aus dem ersten Q-Datenteilsignal und dem zweiten Q-Datenteilsignal in einer gegebenen Probe gleich dem Q-Datensignal in der gegebenen Probe ist.

**7.** Digitales Quadraturleistungsverstärkersystem (100) nach einem der vorhergehenden Ansprüche, wobei mindestens eine von der ersten und der zweiten Digital-zu-HF-Wandlervorrichtung (110, 116) einen entsprechenden Decodierer (122, 124) aufweist, der zwischen dem Wandlereingang (112, 118) und dem digitalen Leistungsverstärker (DPA1, DPA2) angeschlossen ist.

**8.** Digitales Quadraturleistungsverstärkersystem (100) nach Anspruch 7, wobei mindestens ein Teil von einem der digitalen Leistungsverstärker (DPA1, DPA2) unär codiert ist, und wobei der entsprechende Decodierer (122, 124) konfiguriert ist, dem mindestens einen Teil von einem der digitalen Leistungsverstärker (DPA1, DPA2) ein unär codiertes Signal bereitzustellen.

**9.** Digitales Quadraturleistungsverstärkersystem (100) nach Anspruch 7 oder 8, wobei mindestens ein Teil von einem von dem ersten digitalen Leistungsverstärker (DPA1) und dem zweiten digitalen Leistungsverstärker (DPA2) binär codiert ist, und wobei der entsprechende Decodierer (122, 124) konfiguriert ist, dem mindestens einen Teil von einem von dem ersten digitalen Leistungsverstärker (DPA1) und dem zweiten digitalen Leistungsverstärker (DPA2) ein binär codiertes Signal bereitzustellen.

**10.** Digitales Quadraturleistungsverstärkersystem (100) nach einem der vorhergehenden Ansprüche, ferner aufweisend:

einen ersten digitalen Quadraturmodulator (130), der zwischen dem ersten Wandlereingang (112) und dem ersten digitalen Leistungsverstärker (DPA1) angeschlossen ist und konfiguriert ist, mindestens eines von einer Aufwärtswandlung und einer Kombination von dem I-Datenteilsignal des ersten IQ-Datenteilsignals (IQ1) und dem Q-Datenteilsignal des ersten IQ-Datenteilsignals (IQ1) in der digitalen Domäne durchzuführen;
einen zweiten digitalen Quadraturmodulator (132), der zwischen dem zweiten Wandlereingang (118) und dem zweiten digitalen Leistungsverstärker (DPA2) angeschlossen ist und konfiguriert ist, mindestens eines von einer Aufwärtswandlung und einer Kombination von dem I-Datenteilsignal des zweiten IQ-Datenteilsignals (IQ2) und dem Q-Datenteilsignal des zweiten IQ-Datenteilsignals (IQ2) in der digitalen Domäne durchzuführen.

**11.** Digitales Quadraturleistungsverstärkersystem (100) nach einem der vorhergehenden Ansprüche, ferner aufweisend:
Upsampling-Blöcke (UP1, UP2), wobei ein Upsampling-Block zwischen jedem einzelnen von den Teilausgängen (106, 108) und den entsprechenden Wandlereingängen (112, 118) angeordnet ist, wobei jeder Upsampling-Block (UP1, UP2) konfiguriert ist, jedes IQ-Datenteilsignal hochzusamplen und zu filtern.

12. Digitales Quadraturleistungsverstärkersystem (100) nach einem der vorhergehenden Ansprüche, wobei die zweite Digital-zu-HF-Wandlervorrichtung (116) eines von einer geringeren Auflösung und einem geringeren Wirkungsgrad als die erste Digital-zu-HF-Wandlervorrichtung (110) aufweist.

13. Übertragungsvorrichtung (300) für ein drahtloses Kommunikationssystem (400), die ein digitales Quadraturleistungsverstärkersystem (100) nach einem der vorhergehenden Ansprüche aufweist.

14. Verfahren (200) zum Umwandeln eines IQ-Datensignals (IQ) in ein HF-Signal, umfassend die Schritte:

Empfangen (202) eines IQ-Datensignals (IQ), das ein I-Datensignal und ein Q-Datensignal aufweist;
Zerlegen (204) des IQ-Datensignals (IQ) in mindestens ein erstes IQ-Datenteilsignal (IQ1) und ein zweites IQ-Datenteilsignal (IQ2);
Umwandeln (206) des ersten IQ-Datenteilsignals (IQ1) in ein erstes HF-Signal; und
Umwandeln (208) des zweiten IQ-Datenteilsignals (IQ2) in ein zweites HF-Signal,
**gekennzeichnet durch**
Zerlegen des IQ-Datensignals (IQ) in mindestens ein erstes IQ-Datenteilsignal (IQ1), das keine Signalkomponenten oberhalb eines ersten Schwellenpegels in dem IQ-Datensignal (IQ) aufweist, und ein zweites IQ-Datenteilsignal (IQ2), das die Signalkomponenten aufweist, wenn der Signalpegel des IQ-Datensignals (IQ) in einer gegebenen Probe oberhalb des ersten Schwellenpegels liegt.

**Revendications**

1. Système amplificateur de puissance numérique en quadrature (100), comprenant :

un circuit de décomposition (102) comprenant :

une entrée (104) configurée pour recevoir un signal de données IQ (IQ) comprenant un signal de données I et un signal de données Q ; et
une première sous-sortie (106) et une deuxième sous-sortie (108), le circuit de décomposition (102) étant configuré pour décomposer le signal de données IQ (IQ) en au moins un premier sous-signal de données IQ (IQ1) et un deuxième sous-signal de données IQ (IQ2), et pour délivrer le premier sous-signal de données IQ (IQ1) sur la première sous-sortie (106) et le deuxième sous-signal de données IQ (IQ2) sur la deuxième sous-sortie (108) ;

un premier dispositif convertisseur numérique/RF (110), comprenant une première entrée de convertisseur (112) reliée à la première sous-sortie (106) du circuit de décomposition (102), un premier amplificateur de puissance numérique (DPA1) relié à la première entrée de convertisseur (112), et une première sortie (114), le premier dispositif convertisseur numérique/RF (110) étant configuré pour convertir le premier sous-signal de données IQ (IQ1) en un premier signal RF et pour délivrer le premier signal RF sur la première sortie (114) ;
au moins un deuxième dispositif convertisseur numérique/RF (116), comprenant une deuxième entrée de convertisseur (118) reliée à la deuxième sous-sortie (108) du circuit de décomposition (102), un deuxième amplificateur de puissance numérique (DPA2) relié à la deuxième entrée de convertisseur (118), et une deuxième sortie (120), le deuxième dispositif convertisseur numérique/RF (116) étant configuré pour convertir le deuxième sous-signal de données IQ (IQ2) en un deuxième signal RF et pour délivrer le deuxième signal RF sur la deuxième sortie (120),
**caractérisé en ce que**
le circuit de décomposition (102) est configuré pour décomposer le signal de données IQ (IQ) en au moins un premier sous-signal de données IQ (IQ1) ne comprenant pas de composantes de signal au-dessus d'un premier niveau de seuil dans le signal de données IQ (IQ) et un deuxième sous-signal de données IQ (IQ2) comprenant lesdites composantes de signal si le niveau de signal du signal de données IQ (IQ) dans un échantillon donné est supérieur au premier niveau de seuil.

2. Système amplificateur de puissance numérique en quadrature (100) selon la revendication 1, avec lequel la première sortie (114) et la deuxième sortie (120) sont reliées l'une à l'autre.

3. Système amplificateur de puissance numérique en quadrature (100) selon la revendication 1 ou 2, avec lequel le signal de données IQ (IQ) est décomposé de telle sorte que la somme du premier sous-signal de données IQ (IQ1) et du deuxième sous-signal de données IQ (IQ2) dans l'échantillon donné est égale au signal de données IQ (IQ) dans l'échantillon donné.

**4.** Système amplificateur de puissance numérique en quadrature (100) selon la revendication 1, 2 ou 3, avec lequel le niveau de signal du signal de données IQ (IQ) est défini sous la forme $I^2 + Q^2$, $\sqrt{I^2 + Q^2}$, ou abs(I) + abs(Q), où I est la valeur du signal de données I et Q est la valeur du signal de données Q.

**5.** Système amplificateur de puissance numérique en quadrature (100) selon l'une quelconque des revendications précédentes, avec lequel le circuit de décomposition (102) est configuré pour :

décomposer le signal de données I en au moins un premier sous-signal de données I et un deuxième sous-signal de données I, si le signal de données I dans un échantillon donné est supérieur à un deuxième niveau de seuil pour le signal de données I ; et
décomposer le signal de données Q en au moins un premier sous-signal de données Q et un deuxième sous-signal de données Q, si le signal de données Q dans un échantillon donné est supérieur à un troisième niveau de seuil pour le signal de données Q,
le premier sous-signal de données I et le premier sous-signal de données Q constituant le premier sous-signal de données IQ (IQ1), le deuxième sous-signal de données I et le deuxième sous-signal de données Q constituant le deuxième sous-signal de données IQ et le niveau de signal pour le signal de données I étant défini sous la forme abs(I) et le niveau de signal pour le signal de données Q étant défini sous la forme abs(Q).

**6.** Système amplificateur de puissance numérique en quadrature (100) selon la revendication 5, avec lequel le signal de données IQ (IQ) est décomposé de telle sorte que la somme du premier sous-signal de données I et du deuxième sous-signal de données I dans l'échantillon donné est égale au signal de données I dans l'échantillon donné, et de sorte que la somme du premier sous-signal de données Q et du deuxième sous-signal de données Q dans un échantillon donné est égale au signal de données Q dans l'échantillon donné.

**7.** Système amplificateur de puissance numérique en quadrature (100) selon l'une quelconque des revendications précédentes, avec lequel au moins l'un des premier et deuxième dispositifs convertisseurs numérique/RF (110, 116) comprend un décodeur (122, 124) correspondant relié entre l'entrée de convertisseur (112, 118) et l'amplificateur de puissance numérique (DPA1, DPA2).

**8.** Système amplificateur de puissance numérique en quadrature (100) selon la revendication 7, avec lequel au moins une partie de l'un des amplificateurs de puissance numériques (DPA1, DPA2) est codée unaire et avec lequel le décodeur (122, 124) correspondant est configuré pour fournir un signal codé unaire à ladite au moins une partie de l'un des amplificateurs de puissance numériques (DPA1, DPA2).

**9.** Système amplificateur de puissance numérique en quadrature (100) selon la revendication 7 ou 8, avec lequel au moins une partie de l'un parmi le premier amplificateur de puissance numérique (DPA1) et le deuxième amplificateur de puissance numérique (DPA2) est codée binaire et avec lequel le décodeur (122, 124) correspondant est configuré pour fournir un signal codé binaire à ladite au moins une partie de l'un parmi le premier amplificateur de puissance numérique (DPA1) et le deuxième amplificateur de puissance numérique (DPA2).

**10.** Système amplificateur de puissance numérique en quadrature (100) selon l'une quelconque des revendications précédentes, comprenant en outre :

un premier modulateur en quadrature numérique (130) relié entre la première entrée de convertisseur (112) et le premier amplificateur de puissance numérique (DPA1) et configuré pour réaliser au moins l'une parmi la conversion ascendante et la combinaison du sous-signal de données I du premier sous-signal de données IQ (IQ1) et du sous-signal de données Q du premier sous-signal de données IQ (IQ1) dans le domaine numérique ;
un deuxième modulateur en quadrature numérique (132) relié entre la deuxième entrée de convertisseur (118) et le deuxième amplificateur de puissance numérique (DPA2) et configuré pour réaliser au moins l'une parmi la conversion ascendante et la combinaison du sous-signal de données I du deuxième sous-signal de données IQ (IQ2) et du sous-signal de données Q du deuxième sous-signal de données IQ (IQ2) dans le domaine numérique.

**11.** Système amplificateur de puissance numérique en quadrature (100) selon l'une quelconque des revendications précédentes, comprenant en outre : des blocs de suréchantillonnage (UP1, UP2), un bloc de suréchantillonnage étant disposé entre chacune des sous-sorties (106, 108) et les entrées de convertisseur (112, 118) correspondantes, chaque bloc de suréchantillonnage (UP1, UP2) étant configuré pour suréchantillonner et filtrer chaque signal de données IQ.

**12.** Système amplificateur de puissance numérique en quadrature (100) selon l'une quelconque des revendications précédentes, avec lequel le deuxième dispositif convertisseur numérique/RF (116) possède l'une quelconque parmi une résolution plus faible et une efficacité plus faible que le premier dispositif convertisseur numérique/RF (110).

13. Dispositif émetteur (300) pour un système de communication sans fil (400) comprenant un système amplificateur de puissance numérique en quadrature (100) selon l'une quelconque des revendications précédentes.

14. Procédé (200) de conversion d'un signal de données IQ (IQ) en un signal RF, comprenant les étapes suivantes :

réception (202) d'un signal de données IQ (IQ) comprenant un signal de données I et un signal de données Q ;
décomposition (204) du signal de données IQ (IQ) en au moins un premier sous-signal de données IQ (IQ1) et un deuxième sous-signal de données IQ (IQ2) ; conversion (206) du premier sous-signal de données IQ (IQ1) en un premier signal RF ; et
conversion (208) du deuxième sous-signal de données IQ (IQ2) en un deuxième signal RF, **caractérisé par**
décomposition du signal de données IQ (IQ) en au moins un premier sous-signal de données IQ (IQ1) ne comprenant pas de composantes de signal au-dessus d'un premier niveau de seuil dans le signal de données IQ (IQ) et un deuxième sous-signal de données IQ (IQ2) comprenant lesdites composantes de signal si le niveau de signal du signal de données IQ (IQ) dans un échantillon donné est supérieur au premier niveau de seuil.

Fig. 1

Fig. 2

110,116

112,
118

130
132

122
124

DPA1,
DPA2

114,
120

Fig. 3

110,116

112,
118

122
124

130
132

DPA1,
DPA2

114,
120

Fig. 4

Fig. 5

Fig. 6

| Receiving IQ data signal | 202 |

↓

| Decomposing IQ data signal into first IQ data sub-signal and second IQ data sub-signal | 204 |

↓

| Converting first IQ data sub-signal to a first RF signal | 206 |

↓

| Converting second IQ data sub-signal to a second RF signal | 208 |

200 →

Fig. 7

400

A2

300

A1

500

100

100

Fig. 8

**EP 3 363 117 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20140118063 A1